# EUROPEAN PATENT SPECIFICATION

(11) **EP 3 435 502 B1**
(45) Date of publication and mention of the grant of the patent: **07.09.2022**
(21) Application number: 17183072.2
(22) Date of filing: 25.07.2017
(51) Int. Cl.: H02H 3/04, H02H 3/08, H02M 7/12, H03K 17/08, G01R 31/327

(54) **ELECTRONIC CIRUIT COMPRISING A SWITCHING MEANS**
ELEKTRONISCHER SCHALTKREIS MIT EINEM SCHALTMITTEL
CIRCUIT ÉLECTRONIQUE COMPRENANT UN MOYEN DE COMMUTATION

(43) Date of publication of application: 30.01.2019
(73) Proprietor: KONE Corporation, 00330 Helsinki (FI)
(72) Inventor: NIKANDER, Juhamatti, 00330 Helsinki (FI); NAKARI, Arto, 00330 Helsinki (FI)
(74) Representative: Glück Kritzenberger Patentanwälte PartGmbB

(56) References cited:
- EP-A1- 2 887 546
- WO-A2-2016/150714
- US-A- 5 930 132
- US-A1- 2006 214 624
- US-A1- 2014 098 581

## Description

The present invention relates to a passenger conveyor comprising a brake drive and/or motor drive with an electronic circuit comprising a switching means. Circuits of this kind are used for example in motor or brake drives of passenger conveyors as elevators and escalators to separate the motor drive or brake drive from mains. This switching means are usually realized by a relay which is controlled by a control signal of a safety circuit of the passenger conveyor. If any situation occurs wherein the safety does not meet the machine specific safety requirements, the relay is opened and the motor drive or brake drive is separated from mains. It is further important for the passenger conveyor to get information about the status of this safety relay. On this behalf, the electronic circuit comprises a monitoring circuit which gives information about the status of the switching means, i.e. the relay. Via the output signal of the monitoring circuit, the device, for example the escalator or elevator, knows whether or not the corresponding drive has been correctly separated from mains or not.

The conventional switching relays with the corresponding monitoring circuit are reliable and are comparably easily to install. A disadvantage of these components is that switching relays are prone to wear and the switching relays are comparably expensive.

The US 5,930,132 A discloses a low power circuit wherein two switches are provided with a series connection of opto-coupler, resistor and diode between collector and gate driver. In this document the opto-coupler signal is not used to actually monitor the operating state of the semiconductor switch but rather to prevent the case where the switches Q1 and Q2 would be simultaneously switched on.

It is target of the present invention to provide an passenger conveyor having an electronic circuit in its brake drive and/or motor drive comprising a switching means with status monitoring according to the above-mentioned type which is cheaper and which is easy to install and reliable in its operation.

This object is solved with an passenger conveyor according to claim 1. Preferred embodiments of the invention are subject-matter of the dependent claims. Preferred embodiments of the invention are also described in the descriptive part of the application as well as in the drawings.

According to the invention, the switching means of the brake drive and/or motor drive comprises at least one semiconductor switch as the switching element, which semiconductor switch is connected to a gate driver which is controlled by a control signal to effect switching of the semiconductor switch. The gate driver is connected to a gate drive power supply. According to the invention the monitoring circuit is arranged between the semiconductor gate and its collector and it comprises a series connection of an opto-coupler, a current-limiting resistor and a protection diode, which series connection is connected in series with the gate driver power supply.

Thereby, the series diode blocks monitoring current flowing to external circuits. The LED of the opto-coupler will be off when the transistor is in a non-conducting state (OFF) and the LED is on when the transistor is in a conducting state (ON). Thus, the signal output of the opto-coupler will give reliable information about the switching status of the semiconductor switch whereby the whole circuit is comparably cheap, is easy to install and has an essentially longer lifetime than conventional switching relays.

According to the invention, the electronic circuit is part of a motor drive and/or brake drive of a passenger conveyor which might be an escalator or elevator or moving ramp or the like. Particularly in these drives, the use of the electronic circuit as a separation circuit for separating the corresponding drive from mains is a very advantageous measure as the currently used switching relays are subject to wear and are quite expensive. Therefore, the use of the electronic circuits in these drives is particular advantageous.

Preferably, the current-limiting resistor is of a MELF-type to avoid the bypassing of the transistor through the gate power supply and the monitoring circuit in case the transistor is broken.

Preferably, the semiconductor switch is a transistor which is commercially available and which is reliable for said purpose.

In a preferred embodiment of the invention, a parallel diode is connected in parallel, preferably antiparallel, to the semiconductor switch. This feature avoids the monitoring current supplied by the gate drive power supply from powering the load which is switched by the semiconductor switch.

Preferably, a coupler diode is connected in parallel to the opto-coupler to avoid damaging of the opto-coupler by external load peaks which are not generated by the gate driver power supply.

Preferably, the electronic circuit is part of a motor drive comprising a rectifier bridge connected to mains and an inverter bridge connected with a passenger conveyor motor. The rectifier bridge and the inverter bridge are connected via a DC link and the switching means are arranged in a connection between the rectifier bridge and mains. The arrangement of the above-mentioned electronic circuit in this connection is preferably advantageous as high currents are switched which lead to a fast wear of the currently used relays because sometimes the motor drive may be switched off during a high current period which might even lead to lightning sparks when switching off. The switching of the motor drive via the semiconductor switches (normally three semiconductor switches have to be used as switching means, one for each phase) does not lead to any lightning sparks when switching the motor drive on or off.

In an alternative preferred embodiment of the invention the monitoring circuit is configured to indicate fault of the switching means, if the opto-coupler is conducting when the control signal is in OFF-state. Accordingly, the invention is able monitor different fault modes as usually IGBT desaturation circuits indicate a fault in case the opto-coupler is not conducting when the control signal is in ON-state.

The invention obtains a particular cost-saving as in connection with a motor drive or brake drive of a passenger conveyor comparably high currents are switched which lead to a fast wear of conventional relay switches.

It is clear for the skilled person that the above-described embodiments may be combined with each other according to the scope of the claims.

The invention will be described hereinafter by means of an embodiment in connection with the enclosed drawing.
- Fig. 1: shows a prior art switching means formed by a relay switch, and
- Fig. 2: shows an electronic circuit comprising an electronic circuit according to the present invention.

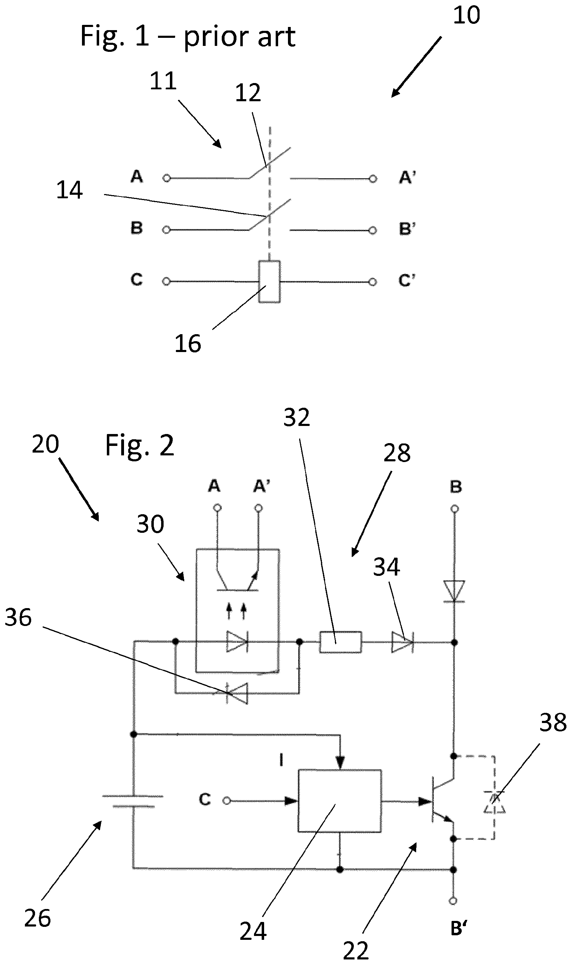

Fig. 1 shows an input section 10 of a motor or brake drive having a switching relay 11 with relay switches 12, 14 which relay switches 12, 14 are activated by a solenoid 16 which is controlled by a control signal C for example of a safety device of an escalator or elevator and which further provides a monitoring signal about the switching status of the relay switches 12, 14. The disadvantage of this currently used switching relay is that it is prone to wear and that it is comparably expensive. As the switching relay switches in a motor drive or brake drive of an elevator or escalator, comparably high currents also lightning sparks may occur at the relay switches 12, 14 which accelerate the wear of the switching relay and affect the reliability of this switching means in total.

The present invention offers a new type of electronic switching circuit 20 comprising a semiconductor switch 22, preferably in form of a transistor. The transistor is connected between a connection point B, for example a rectifier bridge of a motor drive and another connection point B' for example one phase of mains. The transistor 22 is controlled by a gate driver 24 which is powered by a gate driver power supply 26. The gate driver 24 is controlled by a control signal C. Connected in series with the gate driver power supply, a monitoring circuit 28 is provided which comprises a series connection of an opto-coupler 30, a current limiting resistor 32 and a protection diode 34. Optionally, a coupler diode 36 may be connected in parallel to the opto-coupler 30. The current limiting resistor 32 and the protection diode 34 ensure that the opto-coupler is driven in a safe operating condition without current peaks and without load signals from external sources (for example the load B) flowing through the opto-coupler. Via this measure, it is ensured that the opto-coupler is really only driven by the gate driver power supply and the gate driver 24 thus ensuring that the on/off state of the opto-coupler with its outputs A and A' is only dependent on the switching status of the semiconductor switch 22.

Advantageously, a parallel diode 38 is connected antiparallel to the semiconductor switch, e.g. transistor 22 to avoid that the monitoring current supplied by the gate driver power supply has an effect on the load itself.

If the current limiting resistor 32 is of a MELF-type, the bypassing of the transistor through the gate driver power supply and the monitoring circuit is avoided in case the semiconductor switch or transistor 22 is broken.

Via this advantageous electronic circuit 30, on one hand a secure and reliable switching even of high currents is obtained with the semiconductor switch 22 and on the other hand the monitoring circuit 30 enables a reliable output signal A, A' of the opto-coupler 30 dependent only on the switching status of the semiconductor switch 22 to monitor its switching state.

The invention is not restricted to the embodiments specified above but may be varied within the scope of the appended patent claims.

### Table of reference numbers

- 10: input section of a drive
- 11: switching relay
- 12: first relay switch
- 14: second relay switch
- 16: solenoid of the switching relay
- 20: inventive electronic switching circuit
- 22: semiconductor switch - transistor
- 24: gate driver
- 26: gate driver power supply
- 28: monitoring circuit
- 30: opto-coupler
- 32: current limiting resistor
- 34: protection diode
- 36: coupler diode
- 38: (anti)parallel diode

## Claims

1. Passenger conveyor with a brake drive and/or motor drive having an electronic circuit (20) as separation circuit configured to separate the drive from mains, which electronic circuit (20) comprising a switching means (22), having a monitoring circuit (28) configured to monitor the switching status of the switching means, wherein the switching means comprises at least one semiconductor switch (22) as a switching element, which semiconductor switch (22) is connected with its gate to a gate driver (24) which is configured to be controlled by a control signal (C) of a safety circuit of the passenger conveyor to effect switching of the semiconductor switch, the gate driver (24) being supplied by a gate driver power supply (26), whereby the monitoring circuit (28) is arranged between the gate driver (24) and the collector of the semiconductor switch and comprises a series connection of a LED of an opto-coupler (30), a current-limiting resistor (32) and a protection diode (34), which series connection is connected in series with the gate driver power supply (26), the output (A, A') of the opto-coupler (30) is configured to provide a signal for the monitoring of the switching status of the switching means (22).

2. Passenger conveyor according to claim 1, wherein the current-limiting resistor (32) is of a MELF-type.

3. Passenger conveyor according to one of the preceding claims, wherein the semiconductor switch (22) is a transistor.

4. Passenger conveyor according to one of the preceding claims, wherein a parallel diode (38) is connected anti-parallel to the semiconductor switch (22).

5. Passenger conveyor according to one of the preceding claims, wherein a coupler diode (36) is connected in parallel to the opto-coupler (30).

6. Passenger conveyor according to one of the preceding claims, which is an escalator or elevator.

7. Passenger conveyor according to one of the preceding claims, wherein the electronic circuit is is part of a motor drive comprising a rectifier bridge connected to mains and an inverter bridge connected with a passenger conveyor motor, which rectifier bridge and inverter bridge are connected via a DC link, whereby the semiconductor switch (22) is arranged in a connection between the rectifier bridge and mains.

8. Passenger conveyor according to one of the preceding claims, wherein the monitoring circuit (28) is configured to indicate fault of the switching means (22), if the opto-coupler (30) is conducting when the control signal (c) is in OFF-state.

## Patentansprüche

1. Personenbeförderungsanlage mit einem Brems- und/oder Motorantrieb, mit einer elektronischen Schaltung (20) als Trennschaltung, die zum Trennen des Antriebs vom Netz ausgebildet ist, welche elektronische Schaltung (20) ein Schaltmittel (22) mit einer Überwachungsschaltung (28) umfasst , die zum Überwachen des Schaltzustands des Schaltmittels ausgebildet ist, wobei das Schaltmittel mindestens einen Halbleiterschalter (22) als Schaltelement umfasst, welcher Halbleiterschalter (22) mit seinem Gate mit einem Gate-Treiber (24) verbunden ist, der von einem Steuersignal (C) einer Sicherheitsschaltung der Personenbeförderungsanlage zum Schalten des Halbleiterschalters ansteuerbar ausgebildet ist, wobei der Gate-Treiber (24) von einer Gate-Treiber-Stromversorgung (26) versorgt wird, wobei die Überwachungsschaltung (28) zwischen dem Gate-Treiber (24) und dem Kollektor des Halbleiterschalters angeordnet ist und eine Reihenschaltung einer LED eines Optokopplers (30), eines strombegrenzenden Widerstands (32) und einer Schutzdiode (34) umfasst, welche Reihenschaltung in Reihe mit der Gate-Treiber-Spannungsversorgung (26) geschaltet ist, wobei der Ausgang (A, A') des Optokopplers (30) zur Bereitstellung eines Signals zur Überwachung des Schaltzustands der Schaltmittel (22) ausgebildet ist.

2. Personenbeförderungsanlage nach Anspruch 1, in welcher der Strombegrenzungswiderstand (32) von einem MELF-Typ ist.

3. Personenbeförderer nach einem der vorhergehenden Ansprüche, in welcher der Halbleiterschalter (22) ein Transistor ist.

4. Personenbeförderungsanlage nach einem der vorhergehenden Ansprüche, in welcher eine parallele Diode (38) antiparallel zu dem Halbleiterschalter (22) geschaltet ist.

5. Personenbeförderungsanlage nach einem der vorhergehenden Ansprüche, in welcher eine Kopplerdiode (36) parallel zum Optokoppler (30) geschaltet ist.

6. Personenbeförderungsanlage nach einem der vorhergehenden Ansprüche, die eine Rolltreppe oder ein Aufzug ist.

7. Personenbeförderungsanlage nach einem der vorhergehenden Ansprüche, in welcher die elektronische Schaltung Teil eines Motorantriebs ist, der eine mit dem Netz verbundene Gleichrichterbrücke und eine mit einem Personenbeförderungsmotor verbundene Wechselrichterbrücke umfasst, wobei die Gleichrichterbrücke und die Wechselrichterbrücke über einen Zwischenkreis verbunden sind, wobei der Halbleiterschalter (22) in einer Verbindung zwischen der Gleichrichterbrücke und dem Netz angeordnet ist.

8. Personenbeförderungsanlage nach einem der vorhergehenden Ansprüche, wobei die Überwachungsschaltung (28) ausgebildet ist, einen Fehler der Schalteinrichtung (22) anzuzeigen, wenn der Optokoppler (30) leitend ist, wenn das Steuersignal (c) im AUSZustand ist.

## Revendications

1. Transporteur de passagers avec un entraînement de frein et/ou un entraînement de moteur comportant un circuit électronique (20) comme circuit de séparation, configuré pour séparer l'entraînement du réseau électrique, ledit circuit électronique (20) comprenant un moyen de commutation (22), comportant un circuit de surveillance (28) configuré pour surveiller l'état de commutation du moyen de commutation, dans lequel le moyen de commutation comprend au moins un commutateur semi-conducteur (22) comme élément de commutation, ledit commutateur semi-conducteur (22) étant connecté par sa grille à un pilote de grille (24) qui est configuré pour être commandé par un signal de commande (C) d'un circuit de sécurité du transporteur de passagers pour effectuer une commutation du commutateur semi-conducteur, le pilote de grille (24) étant alimenté par une alimentation de pilote de grille (26), moyennant quoi le circuit de surveillance (28) est agencé entre le pilote de grille (24) et le collecteur du commutateur semi-conducteur et comprend une connexion en série d'une DEL d'un optocoupleur (30), d'une résistance de limitation de courant (32) et d'une diode de protection (34), ladite connexion en série étant connectée en série avec l'alimentation du pilote de grille (26), la sortie (A, A') de l'optocoupleur (30) étant configurée pour fournir un signal de surveillance de l'état de commutation du moyen de commutation (22).

2. Transporteur de passagers selon la revendication 1, dans lequel la résistance de limitation de courant (32) est de type face sans fil à électrode métallique, MELF - soit Métal Electrode Leadless Face.

3. Transporteur de passagers selon l'une des revendications précédentes, dans lequel le commutateur semi-conducteur (22) est un transistor.

4. Transporteur de passagers selon l'une des revendications précédentes, dans lequel une diode parallèle (38) est connectée de manière antiparallèle avec le commutateur semi-conducteur (22).

5. Transporteur de passagers selon l'une des revendications précédentes, dans lequel une diode de couplage (36) est connectée en parallèle avec l'optocoupleur (30).

6. Transporteur de passagers selon l'une des revendications précédentes, qui est un escalier mécanique ou un ascenseur.

7. Transporteur de passagers selon l'une des revendications précédentes, dans lequel le circuit électronique est une partie d'un entraînement de moteur comprenant un pont redresseur connecté au réseau électrique et un pont onduleur connecté à un moteur de transporteur de passagers, lesdits pont redresseur et pont onduleur étant connectés via une liaison CC, moyennant quoi le commutateur semi-conducteur (22) est agencé dans une connexion entre le pont redresseur et le réseau électrique.

8. Transporteur de passagers selon l'une des revendications précédentes, dans lequel le circuit de surveillance (28) est configuré pour indiquer un défaut du moyen de commutation (22), si l'optocoupleur (30) est conducteur quand le signal de commande (c) est dans l'état d'ARRÊT.
